# EUROPÄISCHE PATENTSCHRIFT

(11) **EP 2 861 782 B1**
(45) Veröffentlichungstag und Bekanntmachung des Hinweises auf die Patenterteilung: **09.03.2016**
(21) Anmeldenummer: 13726540.1
(22) Anmeldetag: 04.06.2013
(51) Int. Cl.: C23C 18/12, H01L 21/477, H01L 29/24, C23C 18/14, H01L 21/02, H01L 21/18, H01L 31/18, C07F 5/00

(54) **VERFAHREN ZUR HERSTELLUNG INDIUMOXID-HALTIGER SCHICHTEN**
METHOD FOR PRODUCING INDIUM OXIDE-CONTAINING LAYERS
PROCÉDÉ DE FABRICATION DE COUCHES CONTENANT DE L'OXYDE D'INDIUM

(30) Priorität: 13.06.2012 DE 102012209918
(43) Veröffentlichungstag der Anmeldung: 22.04.2015
(73) Patentinhaber: Evonik Degussa GmbH, 45128 Essen (DE)
(72) Erfinder: STEIGER, Jürgen, 111 Tapei City Taiwan (TW); FRÜHLING, Dennis, 45768 Marl (DE); MERKULOV, Alexey, 45665 Recklinghausen (DE); HOPPE, Arne, 44623 Herne (DE)
(86) Internationale Anmeldenummer: PCT/EP2013/061452
(87) Internationale Veröffentlichungsnummer: WO 2013/186082

(56) Entgegenhaltungen:
- WO-A1-2011/020781
- WO-A1-2012/010427
- TUROVA N YA: "Metal oxoalkoxides. Synthesis, properties and structures", RUSSIAN CHEMICAL REVIEWS (USPEKHI KHIMII), INSTITUTE OF PHYSICS PUBLISHING, BRISTOL, GB, Bd. 73, Nr. 11, Januar 2004 (2004-01), Seiten 1041-1064, XP009141757, ISSN: 0036-021X

## Beschreibung

Die Erfindung betrifft ein Verfahren zur Herstellung Indiumoxid-haltiger Schichten, bei dem Verfahren einsetzbare Precursoren und Beschichtungszusammensetzungen.

Indiumoxid (Indium(III)oxid, In₂O₃) ist aufgrund der großen Bandlücke zwischen 3.6 und 3.75 eV (gemessen für aufgedampfte Schichten) [H.S. Kim, P.D. Byrne, A. Facchetti, T.J. Marks; J. Am. Chem. Soc. 2008, 130, 12580-12581] ein vielversprechender Halbleiter. Dünne Filme von wenigen hundert Nanometern Dicke können darüber hinaus eine hohe Transparenz im sichtbaren Spektralbereich von größer als 90 % bei 550 nm aufweisen. In extrem hoch geordneten Indiumoxid-Einkristallen kann man zudem Ladungsträgerbeweglichkeiten von bis zu 160 cm²/Vs messen.

Indiumoxid wird oft vor allem zusammen mit Zinn(IV)-oxid (SnO₂) als halbleitendes Mischoxid ITO eingesetzt. Aufgrund der verhältnismäßig hohen Leitfähigkeit von ITO-Schichten bei gleichzeitiger Transparenz im sichtbaren Spektralbereich findet es unter anderem Anwendung im Bereich von Flüssigkristallbildschirmen (LCD; liquid crystal display), insbesondere als "durchsichtige Elektrode". Diese zumeist dotierten Metalloxid-Schichten werden industriell vor allem durch kostenintensive Aufdampfmethoden im Hochvakuum hergestellt. Indiumoxid-haltige Schichten und ihre Herstellung, insbesondere ITO-Schichten und reine Indiumoxid-Schichten, sowie ihre Herstellung sind somit von großer Bedeutung für die Halbleiter- und Displayindustrie.

Als mögliche Edukte bzw. Precursoren für die Synthese Indiumoxid-haltiger Schichten wird eine Vielzahl von Verbindungsklassen diskutiert. Zu diesen gehören zum Beispiel Indiumsalze. So beschreiben Marks et al. Bauteile, bei deren Herstellung eine Precursorlösung aus InCl₃ sowie der Base Monoethanolamin (MEA) gelöst in Methoxyethanol eingesetzt wird. Nach Aufschleudern (Spin-coating) der Lösung wird die entsprechende Indiumoxid-Schicht durch eine thermische Behandlung bei 400 °C erzeugt. [H.S. Kim, P.D. Byrne, A. Facchetti, T.J. Marks; J. Am. Chem. Soc. 2008, 130, 12580-12581 and supplemental informations].

An anderer Stelle werden als mögliche Edukte bzw. Precursoren für die Indiumoxid-Synthese Indiumalkoxide diskutiert. Unter einem Indiumalkoxid ist dabei eine Verbindung bestehend aus mindestens einem Indiumatom, mindestens einem Alkoxidrest der Formel -OR (R = organischer Rest) und ggf. einem oder mehreren organischen Resten -R, einem oder mehreren Halogenresten und/oder einem oder mehreren Resten -OH oder -OROH zu verstehen.

Im Stand der Technik sind unabhängig von einem möglichen Einsatz für die Indiumoxidbildung verschiedene Indiumalkoxide und Indiumoxoalkoxide beschrieben. Gegenüber den bereits erwähnten Indiumalkoxiden weisen Indiumoxoalkoxide noch mindestens einen weiteren, direkt an ein Indiumatom gebundenen oder mindestens zwei Indiumatome verbrückenden Sauerstoff-Rest (Oxo-Rest) auf.

Mehrotra et al. beschreiben die Herstellung von Indium-tris-Alkoxid In(OR)₃ aus Indium(III)chlorid (InCl₃) mit Na-OR, wobei R für -Methyl, -Ethyl, iso-Propyl, n-, s-, t-Butyl und - Pentyl Reste steht. [S. Chatterjee, S. R. Bindal, R.C. Mehrotra; J. Indian Chem. Soc.1976, 53, 867].

Ein Review-Artikel von Carmalt et al. (Coordination Chemistry Reviews 250 (2006), 682 - 709) beschreibt verschiedene Gallium(III)- und Indium(III)alkoxide und -aryloxide, die zum Teil auch über Alkoxidgruppen verbrückt vorliegen können. Weiterhin wird ein Oxo-zentrierter Cluster der Formel In₅(µ-O)(OⁱPr)₁₃, präziser [In₅(µ₅-O)(µ₃-OⁱPr)₄(µ₂-OⁱPr)₄(OⁱPr)₅] vorgestellt, bei dem es sich um ein Oxo-Alkoxid handelt und der nicht aus [In(OⁱPr)₃] hergestellt werden kann.

Ein Review-Artikel von N.Turova et al., Russian Chemical Reviews 73 (11), 1041-1064 (2004) fasst Synthese, Eigenschaften und Strukturen von Metalloxoalkoxiden, die dort als Precursoren für die Herstellung von oxidischen Materialien über Sol-Gel-Technologie betrachtet werden, zusammen. Neben einer Vielzahl anderer Verbindungen wird die Synthese und Struktur von [Sn₃O(OⁱBu)₁₀(ⁱBuOH)₂], von der bereits erwähnten Verbindung [In₅O(OⁱPr)₁₃]und von [Sn₆O₄(OR)₄] (R = Me, Prⁱ) beschrieben.

Der Artikel von N. Turova et al., Journal of Sol-Gel Science and Technology, 2, 17-23 (1994) präsentiert Ergebnisse von Studien an Alkoxiden, die dort als wissenschaftliche Basis für die Entwicklung von Sol-Gel-Prozessen von Alkoxiden und Alkoxid-basierten Pulvern betrachtet werden. In diesem Kontext wird auch u. a. auf ein vermeintliches "Indiumisopropoxid" eingegangen, das sich als das auch bei Carmalt et al. beschriebene Oxoalkoxid mit einem zentralen Sauerstoffatom und fünf umgebenden Metallatomen der Formel M₅(µ-O)(OⁱPr)₁₃ erwies.

Eine Synthese dieser Verbindung und ihre Kristallstruktur wird von Bradley et al., J. Chem. Soc., Chem. Commun., 1988, 1258 - 1259 beschrieben. Weitere Studien der Autoren führten zu dem Ergebnis, dass die Bildung dieser Verbindung nicht auf eine Hydrolyse von zwischenzeitlich entstandenem In(OⁱPr)₃ zurückzuführen ist (Bradley et al., Polyhedron Vol. 9, No. 5, pp. 719 - 726, 1990). Suh et al., J. Am. Chem. Soc. 2000, 122, 9396 - 9404 stellten weiterhin fest, dass diese Verbindung auch nicht auf thermischem Wege aus In(OⁱPr)₃ herstellbar ist. Außerdem wurde durch Bradley (Bradley et al., Polyhedron Vol. 9, No. 5, pp. 719 - 726, 1990) festgestellt, dass sich diese Verbindung nicht sublimieren lässt.

Metalloxidschichten lassen sich prinzipiell über verschiedene Verfahren herstellen.

Eine Möglichkeit, Metalloxidschichten herzustellen, basiert auf Sputtertechniken. Diese Techniken haben jedoch den Nachteil, dass sie unter Hochvakuum durchgeführt werden müssen. Ein weiterer Nachteil ist, dass die mit ihnen hergestellten Filme viele Sauerstoff-Defekte aufweisen, die das Einstellen einer gezielten und reproduzierbaren Stöchiometrie der Schichten unmöglich machen und somit zu schlechten Eigenschaften der hergestellten Schichten führen.

Eine andere prinzipielle Möglichkeit zur Herstellung von Metalloxidschichten beruht auf chemischer Gasphasenabscheidung. So können zum Beispiel Indiumoxid-haltige Schichten aus Indiumoxid-Precursoren wie Indiumalkoxiden oder Indiumoxoalkoxiden über Gasphasenabscheidung hergestellt werden. So lehrt z. B. US 6,958,300 B2, mindestens einen Metall-Organo-Oxid-Precursor (Alkoxid bzw. Oxoalkoxid) der generischen Formel M¹_{q}(O)ₓ(OR¹)_{y} (q = 1 - 2; x = 0 - 4, y = 1 - 8, M¹ = Metall; z. B. Ga, In oder Zn, R¹ = organischer Rest; Alkoxid für x = 0, Oxo-Alkoxid für ≥ 1) bei der Herstellung von Halbleitern bzw. Metalloxidschichten durch Gasphasenabscheidung wie z. B. CVD oder ALD einzusetzen. Alle Gasphasenabscheidungsprozesse haben jedoch entweder den Nachteil, dass sie i) im Falle einer thermischen Reaktionsführung den Einsatz sehr hoher Temperaturen oder ii) im Falle des Einbringens der erforderlichen Energie für die Zersetzung des Precursors in Form von elektromagnetischer Strahlung hohe Energiedichten erfordern. In beiden Fällen ist es nur mit höchstem apparativem Aufwand möglich, die zur Zersetzung des Precursors benötigte Energie gezielt und einheitlich einzubringen.

Vorteilhaft werden somit Metalloxidschichten über Flüssigphasen-Verfahren hergestellt, d.h. über Verfahren umfassend mindestens einen Verfahrensschritt vor der Konvertierung zum Metalloxid, bei dem das zu beschichtende Substrat mit einer flüssigen Lösung von mindestens einem Precursor des Metalloxids beschichtet, ggf. nachfolgend getrocknet und konvertiert wird. Unter einem Metalloxid-Precursor ist dabei eine thermisch oder mit elektromagnetischer Strahlung zersetzbare Verbindung, mit der in An- oder Abwesenheit von Sauerstoff oder anderen Oxidationsstoffen Metalloxid-haltige Schichten gebildet werden können, zu verstehen. Prominente Beispiele für Metalloxid-Precursoren sind z. B. Metallalkoxide und Metalloxoalkoxide. Prinzipiell kann die Schichtherstellung dabei i) durch Sol-Gel-Prozesse, bei denen die eingesetzten Metallalkoxide in Gegenwart von Wasser durch Hydrolyse und nachfolgende Kondensation zunächst zu Gelen umgesetzt werden und dann in Metalloxide konvertiert werden, oder ii) über Konvertierung aus nichtwässriger Lösung erfolgen.

Dabei gehört auch die Herstellung Indiumoxid-haltiger Schichten aus Indiumalkoxiden aus flüssiger Phase zum Stand der Technik.

Die Herstellung Indiumoxid-haltiger Schichten aus Indiumalkoxiden über Sol-Gel-Verfahren in Gegenwart signifikanter Mengen von Wasser gehört zum Stand der Technik. WO 2008/083310 A1 beschreibt Verfahren zur Herstellung anorganischer Schichten bzw. organischer/anorganischer Hybridschichten auf einem Substrat, bei dem ein Metallalkoxid (z.B. eines der generischen Formel R¹M-(OR²)_{y-x}) oder ein Präpolymer davon auf ein Substrat aufgebracht und dann die resultierende Metallalkoxid-Schicht in Gegenwart von und Reaktion mit Wasser ausgehärtet wird. Bei den einsetzbaren Metallalkoxiden kann es sich u. a. um solche von Indium, Gallium, Zinn oder Zink handeln. Nach diesem Verfahren herstellbare Indiumoxid-haltige Schichten sind jedoch sehr inhomogen, weisen keine zufriedenstellenden elektrischen Eigenschaften auf und sind weiterhin insbesondere nicht hinreichend stabil im Hinblick auf atmosphärische Einflüsse und elektrischen Stress.

JP 2007-042689 A beschreibt Metallalkoxid-Lösungen, die Indiumalkoxide enthalten können, sowie Verfahren zur Herstellung von Halbleiterbauelementen, die diese Metallalkoxid-Lösungen einsetzen. Die Metallalkoxid-Filme werden thermisch behandelt und zur Oxid-Schicht umgewandelt. Auch diese Systeme liefern jedoch nicht ausreichend homogene Filme mit ausreichend guten elektrischen Eigenschaften und ausreichender Stabilität im Hinblick auf atmosphärische Einflüsse und elektrischen Stress. Reine Indiumoxid-Schichten können weiterhin mit dem dort beschriebenen Verfahren nicht hergestellt werden.

WO 2010/094581 A1 beschreibt den Einsatz von Indiumalkoxiden bei der Herstellung von Indiumoxid-haltigen Schichten aus wasserfreien Lösungen. Die resultierenden Schichten sind zwar homogener als bei über Sol-Gel-Prozesse hergestellten Schichten, der Einsatz von Indiumalkoxiden in wasserfreien Systemen hat jedoch immer noch den Nachteil, dass durch die Konvertierung Indiumalkoxid-haltiger Formulierungen zu Indiumoxid-haltigen Schichten keine ausreichend gute elektrische Performance und keine ausreichende Stabilität in Bezug auf atmosphärische Einflüsse und elektrischen Stress der entstehenden Schicht gegeben ist.

WO 2011/072887 A1 offenbart ein Verfahren zur Herstellung von Indiumhalogendialkoxiden der generischen Formel InX(OR)₂ und WO 2011/073005 A2 ein Flüssigphasenverfahren zur Herstellung Indiumoxid-haltiger Schichten einsetzend Zusammensetzungen enthaltend mindestens ein solches Indiumhalogendialkoxid InX(OR)₂. Die resultierenden Indiumalkoxidhaltigen Schichten weisen jedoch - wenngleich die elektrischen Eigenschaften schon verbessert gegenüber dem bis jetzt angeführten Stand der Technik sind - noch keine ausreichend guten elektrischen Eigenschaften und keine ausreichende Stabilität in Bezug auf atmosphärische Einflüsse und elektrischen Stress auf. Dies kann möglicherweise darauf zurückgeführt werden, dass Chloridresten zugeschrieben wird, zu einer Absättigung der Valenzen des Sauerstoffs im resultierenden Metalloxidhalbleiter und somit zu einer Verminderung der Elektronenbeweglichkeit führen (Jeong et al., J. Phys. Chem. C 2011, 115, 11773-11780).

Gemäß WO 2010/122274 A1 kann zwar die Stabilität eines Metalloxid-Halbleiters durch die Zugabe von Alkali- oder Erdalkalimetallen erhöht werden, die resultierenden Schichten haben jedoch keine guten halbleitenden Eigenschaften.

WO 2011/020781 A1 beschreibt schließlich ein Flüssigphasenverfahren zur Herstellung Indiumoxid-haltiger Schichten einsetzend Zusammensetzungen enthaltend Indiumoxoalkoxide der generischen Formel MₓO_{y}(OR)_{z}[O(R'O)_{c}H]ₐX_{b}[R"OH]_{d}, das zu Indiumoxid-Schichten mit gezielter, einheitlicher und reproduzierbarer Stöchiometrie, hoher Homogenität und besserer elektrischer Performance führt. Nachteilig ist jedoch, dass auch diese Indiumoxid-haltigen Schichten noch nicht zu ausreichend guten elektrischen Eigenschaften und vor allem nicht zu einer ausreichenden Stabilität in Bezug auf atmosphärische Einflüsse (insbesondere gegenüber in der Atmosphäre enthaltenem Sauerstoff und/oder Wasser) und elektrischen Stress (insbesondere noch keine ausreichende Stabilität im negativen Bias-Stress) führen

Es ist somit die Aufgabe der vorliegenden Erfindung, ein Verfahren zur Herstellung Indiumoxid-haltiger Schichten bereitzustellen, das die Nachteile des Standes der Technik vermeidet. Dabei soll insbesondere ein Verfahren bereitgestellt werden, das zu Indiumoxid-Schichten mit gezielter, einheitlicher und reproduzierbarer Stöchiometrie, hoher Homogenität, guter elektrischer Performance und guter Stabilität im Hinblick auf atmosphärische Einflüsse und elektrischen Stress führt.

Diese Aufgaben werden gelöst durch ein Flüssigphasen-Verfahren zur Herstellung Indiumoxid-haltiger Schichten, bei dem eine Zusammensetzung enthaltend i) mindestens ein Indiumoxoalkoxid der generischen Formel MₓO_{y}(OR)_{z}[O(R'O)ₑH]ₐX_{b}Y_{c}[R"OH]_{d} mit M = In, x = 3 - 25, y = 1 - 10, z = 3 - 50, a = 0 - 25, b = 0 - 20, c = 1 - 20, d = 0 - 25, e = 0,1, R, R', R" = organischer Rest, X = F, Cl, Br, I, und Y = -NO₃, -NO₂, mit der Maßgabe, dass b + c = 1 - 20 ist, und ii) mindestens ein Lösemittel auf ein Substrat aufgebracht, ggf. getrocknet, und in eine Indiumoxid-haltige Schicht konvertiert wird. Bevorzugte Reste R, R' und R" sind C1-C15-Alkyl-, -Alkoxyalkyl-, -Aryl- oder-Oxyarylalkylgruppen (wobei das Präfix C1-C15 jeweils für Reste mit 1 bis 15 Kohlenstoffatomen steht), und besonders bevorzugte Reste R, R' und R" sind = -CH₃, -CH₂CH₃, -CH₂CH₂OCH₃, -CH(CH₃)₂, -CH(CH₃)CH₂OCH₃, -C(CH₃)₃ und

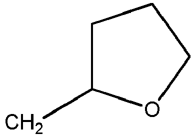

Bei dem erfindungsgemäßen Flüssigphasen-Verfahren zur Herstellung Indiumoxid-haltiger Schichten aus Lösung handelt es sich um ein Verfahren umfassend mindestens einen Verfahrensschritt, bei dem das zu beschichtende Substrat mit einer flüssigen Lösung enthaltend mindestens einen Metalloxid-Precursor beschichtet und ggf. nachfolgend getrocknet wird. Insbesondere handelt es sich dabei nicht um einen Sputter- oder CVD-Prozess. Das erfindungsmäße Flüssigphasen-Verfahren kann entweder mit nichtwässrigen Zusammensetzungen oder als Sol-Gel-Prozess mit wässrigen Zusammensetzungen durchgeführt werden. Bevorzugt ist das erfindungsgemäße Verfahren ein wasserfreies Verfahren. Unter einem Metalloxid-Precursor ist dabei eine thermisch oder mit elektromagnetischer Strahlung zersetzbare Verbindung zu verstehen, mit der in An- oder Abwesenheit von Sauerstoff oder anderen Oxidationsstoffen Metalloxid-haltige Schichten gebildet werden können. Unter flüssigen Zusammensetzungen im Sinne der vorliegenden Erfindung sind solche zu verstehen, die bei SATP-Bedingungen ("Standard Ambient Temperature and Pressure"; T = 25 °C und p = 1013 hPa) und bei Aufbringen auf das zu beschichtende Substrat flüssig vorliegen. Unter einer nichtwässrigen Lösung bzw. einer wasserfreien Zusammensetzung ist dabei hier und im Folgenden eine Lösung bzw. Formulierung zu verstehen, die nicht mehr als 200 ppm H₂O aufweist. Entsprechend weisen wässrige Zusammensetzungen darüberliegende Wassergehalte auf.

Unter dem Verfahrensprodukt des erfindungsgemäßen Verfahrens, der Indiumoxid-haltigen Schicht, ist dabei eine metall- bzw. halbmetallhaltige Schicht zu verstehen, die Indiumatome bzw. -ionen aufweist, die im Wesentlichen oxidisch vorliegen. Gegebenenfalls kann die Indiumoxid-haltige Schicht auch noch Carben-, Halogen- oder Alkoxid-Anteile aus einer nicht vollständigen Konvertierung oder einer unvollständigen Entfernung entstehender Nebenprodukte aufweisen. Die Indiumoxid-haltige Schicht kann dabei eine reine Indiumoxid-Schicht sein, d.h. bei Nichtberücksichtigung etwaiger Carben-, Alkoxid- oder Halogen-Anteile im Wesentlichen aus oxidisch vorliegenden Indiumatomen bzw. -ionen bestehen, oder anteilig noch weitere Metalle, die selbst in elementarer oder oxidischer Form vorliegen können, aufweisen. Zur Erzeugung reiner Indiumoxid-Schichten sollten bei dem erfindungsgemäßen Verfahren nur Indium-haltige Precursoren, bevorzugt nur Indiumoxoalkoxidverbindungen und ggf. Indiumalkoxide, eingesetzt werden. Im Gegensatz dazu sind zur Erzeugung auch andere Metalle aufweisender Schichten neben den Indium-haltigen Precursoren auch Precursoren von Metallen in der Oxidationsstufe 0 (zur Herstellung von Schichten enthaltend weitere Metalle in neutraler Form) bzw. Metalloxid-Precursoren (wie z. B. andere Metallalkoxide oder - oxoalkoxide) einzusetzen.

Die erfindungsgemäßen, bislang nicht in der Literatur beschriebenen Precursoren der generischen Formel MₓO_{y}(OR)_{z}[O(R'O)ₑH]ₐX_{b}Y_{b}[R"OH]_{d} lassen sich z.B. durch Umsetzung von AgNO₃ bzw. einer tendenziell ionischen Verbindung, deren Kation eine schwerlösliche Chloridverbindung im Reaktionsmedium bildet, mit im Stand der Technik bereits bekannten Verbindungen MₓO_{y}(OR)_{z}[O(R'O)_{c}H]ₐX_{b}[R"OH]_{d} mit x = 3 - 25, y = 1 - 10, z = 3 - 50, a = 0 - 25, b = 0 - 20, c = 0, 1, d = 0 - 25, M = In, R, R', R" = organischer Rest, und X = F, Cl, Br, I herstellen. Geeignet ist auch die Umsetzung von In₆O₂X₆(OR)₆(R'CH(O)COOR")₂(HOR)ₓ(HNR'"₂)_{y} (vgl. WO 2012/010427 A1) oder In₇O₂(OH)(OR)₁₂X₄(ROH)ₓ (vgl. WO 2012/010464 A1) mit den gleichen Reagenzien. Geeignet ist auch die Synthese aus gemäß WO 2011/072887 A1 herstellbaren halogenhaltigen Indiumhalogendialkoxiden der generischen Formel InX(OR)₂.

Besonders stabile Schichten können mit Indiumoxoalkoxiden erreicht werden, die im wesentlichen keine Halogenreste mehr aufweisen, d.h. mit solchen Verbindungen der generischen Formel MₓO_{y}(OR)_{z}[O(R'O)ₑH]ₐX_{b}Y_{c}[R"OH]_{d}, bei denen b = 0 ist.

Bevorzugt handelt es sich bei dem Indiumoxoalkoxid um ein solches der generischen Formel MₓO_{y}(OR)_{z}Y_{c} mit x = 3 - 20, y = 1 - 8, z = 3 - 25, c = 1 - 20, OR = C1-C15-Alkoxy-, -Oxyalkylalkoxy, -Aryloxy- oder -Oxyarylalkoxygruppe, Y = -NO₃ und besonders bevorzugt um ein solches der generischen Formel MₓO_{y}(OR)_{z}Y_{c} mit x = 3 - 15, y = 1 - 5, z = 10 - 20, c = 4 - 10, R = = -CH₃, -CH₂CH₃, -CH₂CH₂OCH₃, -CH(CH₃)₂, -CH(CH₃)CH₂OCH₃, -C(CH₃)₃ und/oder 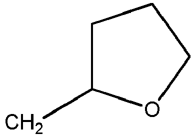 und Y = -NO₃. Diese haben den Vorteil, für die Herstellung von Schichten mit besonders guter Stabilität in Bezug auf atmosphärische Einflüsse und elektrischen Stress geeignet sind.

Ganz besonders bevorzugt ist ein Verfahren, bei dem das eingesetzte Indiumoxoalkoxid aus einem Edukt der generischen Formel In(OCH₃)₂Cl herstellbar ist.

Das vorliegende erfindungsgemäße Verfahren ist besonders gut geeignet zur Herstellung von Indiumoxidschichten, wenn das Indiumoxoalkoxid als einziger Metalloxid-Precursor, eingesetzt wird. Ganz besonders gute Schichten resultieren, wenn der einzige Metalloxid-Precursor die generische Formel In₆O(OCH₂CH₂OCH₃)₁₀(NO₃)₆ hat.

Das mindestens eine Indiumoxoalkoxid liegt bevorzugt in Anteilen von 0,1 bis 15 Gew.-%, besonders bevorzugt 1 bis 10 Gew.-%, ganz besonders bevorzugt 2 bis 5 Gew.-% bezogen auf die Gesamtmasse der Zusammensetzung vor.

Die Zusammensetzung enthält weiterhin mindestens ein Lösemittel, d.h. die Zusammensetzung kann sowohl ein Lösemittel oder ein Gemisch verschiedener Lösemittel enthalten. Vorzugsweise für das erfindungsgemäße Verfahren in der Formulierung einsetzbar sind aprotische und schwach protische Lösemittel, d.h. solche ausgewählt aus der Gruppe der aprotischen unpolaren Lösemittel, d.h. der Alkane, substituierten Alkane, Alkene, Alkine, Aromaten ohne oder mit aliphatischen oder aromatischen Substituenten, halogenierten Kohlenwasserstoffe, Tetramethylsilan, der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat und der schwach protischen Lösemittel, d.h. der Alkohole, der primären und sekundären Amine und Formamid. Besonders bevorzugt einsetzbare Lösemittel sind Alkohole sowie Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether. Ganz besonders bevorzugte Lösemittel sind Methanol, Ethanol, Isopropanol, Tetrahydrofurfurylalkohol, 1-Methoxy-2-propanol, tert-Butanol und Toluol sowie ihre Gemische.

Bevorzugt weist die bei dem erfindungsgemäßen Verfahren eingesetzte Zusammensetzung zur Erzielung einer besonders guten Verdruckbarkeit oder Beschichtbarkeit eine Viskosität von 1 mPa·s bis 10 Pa·s, insbesondere 1 mPa·s bis 100 mPa·s bestimmt nach DIN 53019 Teil 1 bis 2 und gemessen bei 20 °C auf. Entsprechende Viskositäten können durch Zugabe von Polymeren, Cellulosederivaten, oder z.B. unter der Handelsbezeichnung Aerosil erhältlichem SiO₂, und insbesondere durch PMMA, Polyvinylalkohol, Urethanverdicker oder Polyacrylatverdicker eingestellt werden.

Bei dem Substrat, das bei dem erfindungsgemäßen Verfahren eingesetzt wird, handelt es sich bevorzugt um ein Substrat bestehend aus Glas, Silicium, Siliciumdioxid, einem Metall-oder Übergangsmetalloxid, einem Metall oder einem polymeren Material, insbesondere PI oder PET. Das erfindungsgemäße Verfahren ist besonders vorteilhaft ein Beschichtungsverfahren ausgewählt aus Druckverfahren (insbesondere Flexo/Gravur-Druck, Inkjet-Druck, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating. Ganz besonders bevorzugt ist das erfindungsgemäße Beschichtungsverfahren ein Druckverfahren.

Nach der Beschichtung und vor der Konvertierung kann das beschichtete Substrat weiterhin getrocknet werden. Entsprechende Maßnahmen und Bedingungen hierfür sind dem Fachmann bekannt.

Die Konvertierung zu einer Indiumoxid-haltigen Schicht kann auf thermischem Wege und/oder durch Bestrahlung mit elektromagnetischer, insbesondere aktinischer Strahlung erfolgen. Bevorzugt erfolgt die Konvertierung auf dem thermischen Wege durch Temperaturen von größer als 150 °C. Besonders gute Ergebnisse können jedoch erzielt werden, wenn zur Konvertierung Temperaturen von 250 °C bis 360 °C eingesetzt werden.

Dabei werden typischerweise Konvertierungszeiten von einigen Sekunden bis hin zu mehreren Stunden verwendet.

Die thermische Konvertierung kann weiterhin dadurch unterstützt werden, dass vor, während oder nach der thermischen Behandlung UV-, IR- oder VIS-Strahlung eingestrahlt oder das beschichtete Substrat mit Luft bzw. Sauerstoff behandelt wird.

Die Güte der nach dem erfindungsgemäßen Verfahren erzeugten Schicht kann weiterhin durch eine an den Konvertierungsschritt anschließende kombinierte Temperatur- und Gasbehandlung (mit H₂ oder O₂), Plasmabehandlung (Ar-, N₂, O₂ oder H₂-Plasma), Laser-Behandlung (mit Wellenlängen im UV-, VIS- oder IR-Bereich) oder eine Ozon-Behandlung weiter verbessert werden.

Gegenstand der vorliegenden Erfindung sind weiterhin die bislang in der Literatur nicht beschriebenen Indiumoxoalkoxide der generischen Formel MₓO_{y}(OR)_{z}[O(R'O)ₑH]ₐX_{b}Y_{c}[R"OH]_{d} mit M = In, x = 3 - 25, y = 1 - 10, z = 3 - 50, a = 0 - 25, b = 0 - 20, c = 1 - 20, d = 0 - 25, e = 0,1, R, R', R" = organischer Rest, X = F, Cl, Br, I, und Y = -NO₃, -NO₂, wobei b + c = 1 - 20 ist, und ihre bereits zuvor beschriebenen ebenfalls aus der der Literatur nicht bekannten bevorzugten Formen sowie Beschichtungszusammensetzungen, die mindestens ein erfindungsgemäßes Indiumoxoalkoxid und mindestens ein Lösemittel aufweisen.

Dabei kann die Zusammensetzung sowohl ein Lösemittel als auch ein Gemisch verschiedener Lösemittel enthalten. Vorzugsweise für das erfindungsgemäße Verfahren in der Formulierung einsetzbar sind aprotische und schwach protische Lösemittel, d. h. solche ausgewählt aus der Gruppe der aprotischen unpolaren Lösemittel, d. h. der Alkane, substituierten Alkane, Alkene, Alkine, Aromaten ohne oder mit aliphatischen oder aromatischen Substituenten, halogenierten Kohlenwasserstoffe, Tetramethylsilan, der Gruppe der aprotischen polaren Lösemittel, d.h. der Ether, aromatischen Ether, substituierten Ether, Ester oder Säureanhydride, Ketone, tertiäre Amine, Nitromethan, DMF (Dimethylformamid), DMSO (Dimethylsulfoxid) oder Propylencarbonat und der schwach protischen Lösemittel, d. h. der Alkohole, der primären und sekundären Amine und Formamid. Besonders bevorzugt einsetzbare Lösemittel sind Alkohole sowie Toluol, Xylol, Anisol, Mesitylen, n-Hexan, n-Heptan, Tris-(3,6-dioxaheptyl)-amin (TDA), 2-Aminomethyltetrahydrofuran, Phenetol, 4-Methylanisol, 3-Methylanisol, Methylbenzoat, N-Methyl-2-pyrrolidon (NMP), Tetralin, Ethylbenzoat und Diethylether. Ganz besonders bevorzugte Lösemittel sind Methanol, Ethanol, Isopropanol, Tetrahydrofurfurylalkohol, 1-Methoxy-2-propanol, tert-Butanol und Toluol sowie ihre Gemische.

Besonders gute Eigenschaften haben über das erfindungsgemäße Verfahren herstellbare Indiumoxid-haltige Schichten, die reine Indiumoxidschichten sind.

Die über das erfindungsgemäße Verfahren herstellbaren Indiumoxid-haltigen Schichten eignen sich vorteilhaft für die Herstellung elektronischer Bauteile, insbesondere die Herstellung von Transistoren (insbesondere Dünnschichttransistoren), Dioden, Sensoren oder Solarzellen. Das nachfolgende Beispiel soll den Gegenstand der vorliegenden Erfindung näher erläutern.

### Beispiele:

### Beispiel 1

### Synthese

### a) Synthese des erfindungsgemäßen Stoffes in Methanol

Die Synthese wird unter Ausschluss von Luftsauerstoff durchgeführt.
Es werden 25 g (1,0 Gew-%) Indiumchlordimethoxid in 3 L wasserfreiem Methanol gelöst. Anschließend werden 17,62 g Silbernitrat zugegeben und unter Lichtausschluss 12 h gerührt. Der entstehende Feststoff (Nebenprodukt) wird abfiltriert und die klare Lösung bei 40 °C unter Vakuum eingedampft. Der zurückbleibende Feststoff (Produkt) wird 12 h bei 1 mbar getrocknet und abgefüllt.

### b) Synthese des erfindungsgemäßen Stoffes in 2-Methoxyethanol

Die Synthese wird unter Ausschluss von Luftsauerstoff durchgeführt.
Es werden 2,5 g (4,9 Gew-%) Indiumchlordimethoxid in 50 mL wasserfreiem 2-Methoxyethanol gelöst. Anschließend werden 1,76 g Silbernitrat zugegeben und unter Lichtausschluss 12h gerührt. Der entstehende Feststoff (Nebenprodukt) wird abfiltriert und die klare Lösung bei 40°C unter Vakuum eingedampft. Der zurückbleibende Feststoff (Produkt) wird 12h bei 1 mbar getrocknet und abgefüllt.

### c) Synthese des erfindungsgemäßen Stoffes in Tetrahydrofurfurylalkohol

Die Synthese wird unter Ausschluss von Luftsauerstoff durchgeführt.
Es werden 2,5 g (4,5 Gew-%) Indiumchlordimethoxid in 50 mL wasserfreiem Tetrahydrofurfurylalkohol gelöst. Anschließend werden 1,76 g Silbernitrat zugegeben und unter Lichtausschluss > 12h gerührt. Der entstehende Feststoff (Nebenprodukt) wird abfiltriert und die klare Lösung bei 40°C unter Vakuum eingedampft. Der zurückbleibende Feststoff (Produkt) wird 12h bei 1 mbar getrocknet und abgefüllt.

### Beispiel 2

### Prozessierung von TFTs und Stresstests

### a) erfindungsgemäßes Beispiel

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl einer 5 Gew.-% Lösung enthaltend das gemäß Beispiel 1b) gebildete Produkt in 2-Methoxyethanol per Spin-Coating (2000 rpm 30s) beschichtet. Nach dem Beschichtungsvorgang wurde das beschichtete Substrat an der Luft bei einer Temperatur von 350 °C 1 h lang getempert. Die Halbleiterschicht wurde mit einer Schicht aus Polydimethylsiloxan (PDMSi) passiviert. Die Lösung vom PDMSi aus BuOH wurde mittels Spin-Coating aufgetragen und die Probe anschließend 1h bei 350°C getempert.

### a) Vergleichsbeispiel

Ein dotiertes Siliciumsubstrat mit einer Kantenlänge von etwa 15 mm und mit einer ca. 200 nm dicken Siliciumoxid-Beschichtung und Fingerstrukturen aus ITO/Gold wurde mit 100 µl einer 5 Gew.-% Lösung enthaltend Indiumchlordimethoxid in 2-Methoxyethanol per Spin-Coating (2000 rpm 30s) beschichtet. Nach dem Beschichtungsvorgang wurde das beschichtete Substrat an der Luft bei einer Temperatur von 350°C 1 h lang getempert. Die Halbleiterschicht wurde mit einer Schicht aus Polydimethylsiloxan (PDMSi) passiviert. Die Lösung vom PDMSi aus BuOH wurde mittels Spin-Coating aufgetragen und die Probe anschließend 1 h bei 350°C getempert.

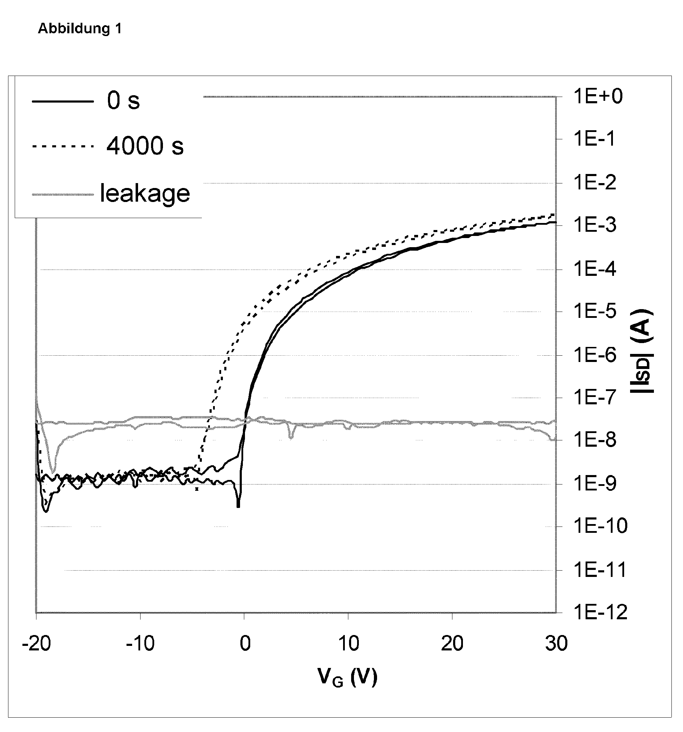

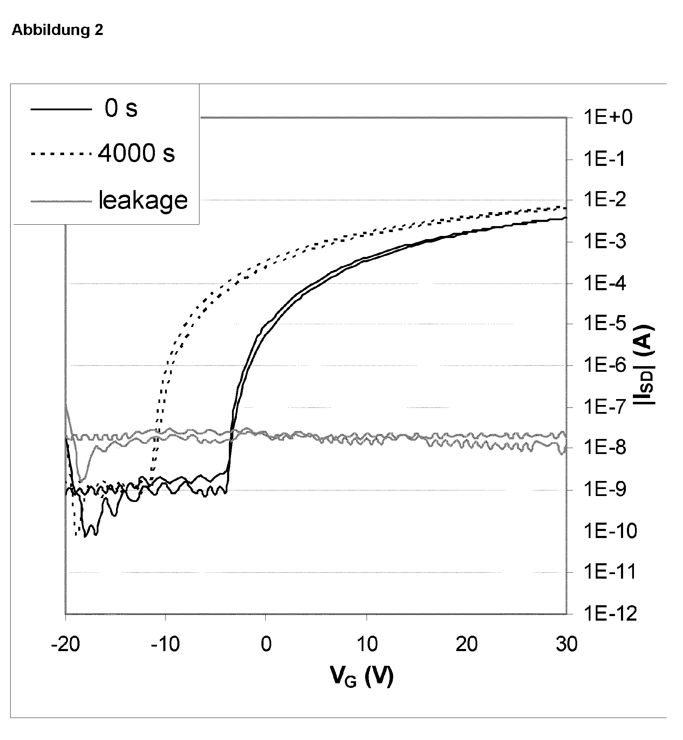

Die Beschichtung zeigt (vgl. Abbildung 1) bessere elektrische Stabilität im negativen Bias-Stress (Vgs = -20V, Vds = 5V , t = 4000s) als die Vergleichsschicht (Abbildung 2). Die Verschiebung der OnSet-Spannung beträgt -3.5V und -7.5V. Weiterhin weist die Beschichtung eine bessere Stabilität auf atmosphärische Einflüsse, insbesondere auf.

Die beiden Abbildungen zeigen die jeweiligen Transferkennlinien bei Vds = 10V; TFT (2000 µm Kanalbreite und 20 µm Kanallänge).

## Patentansprüche

1. Flüssigphasen-Verfahren zur Herstellung Indiumoxid-haltiger Schichten,
**dadurch gekennzeichnet, dass**
eine Zusammensetzung enthaltend
i) mindestens ein Indiumoxoalkoxid der generischen Formel
MₓO_{y}(OR)_{z}[O(R'O)ₑH]ₐX_{b}Y_{c}[R"OH]_{d}
mit x = 3 - 25,
y=1-10,
z = 3 - 50,
a = 0 - 25,
b = 0 - 20,
c = 1 - 20,
d = 0 - 25,
e = 0, 1,
M = In,
R, R', R" = organischer Rest,
X = F, Cl, Br, I,
Y = -NO₃ -NO₂,
mit der Maßgabe, dass b + c = 1 - 20 ist, und
ii) mindestens ein Lösemittel
auf ein Substrat aufgebracht, ggf. getrocknet, und in eine Indiumoxid-haltige Schicht konvertiert wird.

2. Verfahren nach Anspruch 1,
**dadurch gekennzeichnet, dass**
als mindestens ein Indiumoxoalkoxid ein Oxoalkoxid der Formel MₓO_{y}(OR)_{z}Y_{c} mit x = 3 - 20, y = 1 - 8, z = 3 - 25, c = 1 - 20, OR = C1-C15-Alkoxy-, -Oxyalkylalkoxy, -Aryloxy-oder -Oxyarylalkoxygruppe und Y = -NO₃;
besonders bevorzugt ein solches der generischen Formel MₓO_{y}(OR)_{z}Y_{c} mit x = 3 - 15, y = 1 - 5, z = 10 - 20, c = 4 - 10,
R = -CH₃, -CH₂CH₃, -CH₂CH₂OCH₃, -CH(CH₃)₂, -CH(CH₃)CH₂OCH₃, -C(CH₃)₃ und/oder 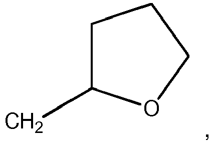 und Y = NO₃ eingesetzt wird.

3. Verfahren nach einem der vorhergehenden Ansprüche,
**dadurch gekennzeichnet, dass**
das mindestens eine Indiumoxoalkoxid der einzige bei dem Verfahren eingesetzte Metalloxid-Precursor ist.

4. Verfahren nach einem der vorhergehenden Ansprüche,
**dadurch gekennzeichnet, dass**
das mindestens eine Indiumoxoalkoxid in Anteilen von 0,1 bis 15 Gew.-% bezogen auf die Gesamtmasse der Zusammensetzung vorliegt.

5. Verfahren nach einem der vorhergehenden Ansprüche,
**dadurch gekennzeichnet, dass**
das mindestens eine Lösemittel ein aprotisches oder schwach protisches Lösemittel ist.

6. Verfahren nach einem Anspruch 5,
**dadurch gekennzeichnet, dass**
das mindestens eine Lösemittel ausgewählt wurde aus der Gruppe bestehend aus Methanol, Ethanol, Isopropanol, Tetrahydrofurfurylalkohol, 1-Methoxy-2-propanol, tert-Butanol und Toluol.

7. Verfahren nach einem der vorhergehenden Ansprüche,
**dadurch gekennzeichnet, dass**
die Zusammensetzung eine Viskosität von 1 mPa·s bis 10 Pa·s aufweist.

8. Verfahren nach einem der vorhergehenden Ansprüche,
**dadurch gekennzeichnet, dass**
das Substrat aus Glas, Silicium, Siliciumdioxid, einem Metall- oder Übergangsmetalloxid, einem Metall oder einem polymeren Material besteht.

9. Verfahren nach einem der vorhergehenden Ansprüche,
**dadurch gekennzeichnet, dass**
das Aufbringen der wasserfreien Zusammensetzung auf das Substrat über ein Beschichtungsverfahren, Druckverfahren, ein Sprühverfahren, ein Rotationsbeschichtungsverfahren, ein Tauchverfahren oder ein Verfahren ausgewählt aus der Gruppe bestehend aus Meniscus Coating, Slit Coating, Slot-Die Coating, und Curtain Coating erfolgt.

10. Verfahren nach einem der vorhergehenden Ansprüche,
**dadurch gekennzeichnet, dass**
die Konvertierung thermisch durch Temperaturen größer 150 °C erfolgt.

11. Verfahren nach Anspruch 10,
**dadurch gekennzeichnet, dass**
vor, während oder nach der thermischen Behandlung UV-, IR- oder VIS-Strahlung eingestrahlt wird.

12. Indiumoxoalkoxid der generischen Formel MₓO_{y}(OR)_{z}[O(R'O)ₑH]ₐX_{b}Y_{c}[R"OH]_{d}
mit x = 3 - 25,
y=1-10,
z = 3 - 50,
a = 0 - 25,
b = 0 - 20,
c = 1 - 20,
d = 0 - 25,
e=0, 1,
M = In,
R, R', R" = organischer Rest,
X = F, Cl, Br, I,
Y = -NO₃, -NO₂,
mit der Maßgabe, dass b + c = 1 - 20 ist.

13. Beschichtungszusammensetzung, enthaltend mindestens ein Indiumoxoalkoxid nach Anspruch 12 und mindestens ein Lösemittel.

## Claims

1. Liquid phase process for producing indium oxide-containing layers,
**characterized in that**
a composition comprising
i) at least one indium oxo alkoxide of the generic formula
MₓO_{y}(OR)_{z}[O(R'O)ₑH]ₐX_{b}Y_{c}[R"OH]_{d}
where
x = 3 - 25,
y = 1 - 10,
z = 3 - 50,
a = 0 - 25,
b = 0 - 20,
c = 1 - 20,
d = 0 - 25,
e = 0, 1,
M = In,
R, R', R" = organic radical,
X = F, Cl, Br, I,
Y = -NO₃, -NO₂,
with the proviso that b + c = 1 - 20, and
ii) at least one solvent
is applied to a substrate, optionally dried and converted to an indium oxide-containing layer.

2. Process according to Claim 1,
**characterized in that**
the at least one indium oxo alkoxide used is an oxo alkoxide of the formula MₓO_{y}(OR)_{z}Y_{c} where x = 3 - 20, y = 1 - 8, z = 3 - 25, c = 1 - 20, OR = C1-C15-alkoxy, -oxyalkylalkoxy, -aryloxy or -oxyarylalkoxy groups and Y = -NO₃;
more preferably one of the generic formula MₓO_{y}(OR)_{z}Y_{c} where x = 3 - 15, y = 1 - 5, z = 10 - 20, c = 4 - 10,
R = -CH₃, -CH₂CH₃, -CH₂CH₂OCH₃, -CH(CH₃)₂, - CH(CH₃)CH₂OCH₃, -C(CH₃)₃ and/or 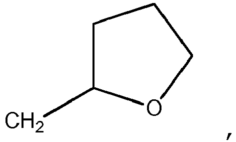 and Y = NO₃.

3. Process according to any of the preceding claims,
**characterized in that**
the at least one indium oxo alkoxide is the sole metal oxide precursor used in the process.

4. Process according to any of the preceding claims,
**characterized in that**
the at least one indium oxo alkoxide is present in proportions of 0.1 to 15% by weight, based on the total mass of the composition.

5. Process according to any of the preceding claims,
**characterized in that**
the at least one solvent is an aprotic or weakly protic solvent.

6. Process according to Claim 5,
**characterized in that**
the at least one solvent was selected from the group consisting of methanol, ethanol, isopropanol, tetrahydrofurfuryl alcohol, 1-methoxy-2-propanol, tert-butanol and toluene.

7. Process according to any of the preceding claims,
**characterized in that**
the composition has a viscosity of 1 mPa·s to 10 Pa·s.

8. Process according to any of the preceding claims,
**characterized in that**
the substrate consists of glass, silicon, silicon dioxide, a metal oxide or transition metal oxide, a metal or a polymeric material.

9. Process according to any of the preceding claims,
**characterized in that**
the aqueous composition is applied to the substrate by means of a coating process, printing process, a spraying process, a rotary coating process, a dipping process, or a process selected from the group consisting of meniscus coating, slit coating, slot-die coating and curtain coating.

10. Process according to any of the preceding claims,
**characterized in that**
the conversion is effected thermally by means of temperatures greater than 150°C.

11. Process according to Claim 10,
**characterized in that**
UV, IR or VIS radiation is injected before, during or after the thermal treatment.

12. Indium oxo alkoxide of the generic formula
MₓO_{y}(OR)_{z}[O(R'O)ₑH]ₐX_{b}Y_{c}[R"OH]_{d}
where x = 3 - 25,
y = 1 - 10,
z = 3 - 50,
a = 0 - 25,
b = 0 - 20,
c = 1 - 20,
d = 0 - 25,
e = 0, 1,
M = In,
R, R', R " = organic radical,
X = F, Cl, Br, I,
Y = -NO₃, -NO₂,
with the proviso that b + c = 1 - 20.

13. Coating composition comprising at least one indium oxo alkoxide according to Claim 12 and at least one solvent.

## Revendications

1. Procédé en phase liquide pour la production de couches contenant de l'oxyde d'indium, **caractérisé en ce qu'**une composition contenant
i) au moins un oxoalcoxyde d'indium de formule générique
MₓO_{y}(OR)_{z}[O(R'O)ₑHₐX_{b}Y_{c}[R"OH]_{d}
dans laquelle
x = 3 - 25,
y = 1 - 10,
z = 3 - 50,
a = 0 - 25,
b = 0 - 20,
c = 1 - 20,
d = 0 - 25,
e = 0, 1,
M = In,
R, R', R" = un radical organique,
X = F, Cl, Br, I,
Y = -NO₃, -NO₂,
à condition que b + c = 1 - 20, et
ii) au moins un solvant
est appliquée sur un substrat, le cas échéant séchée et convertie en une couche contenant de l'oxyde d'indium.

2. Procédé selon la revendication 1, **caractérisé en ce qu'**on utilise, comme au moins un oxoalcoxyde d'indium, un oxoalcoxyde de formule MₓO_{y}(OR)_{z}Y_{c} dans laquelle x = 3-20, y = 1-8, z = 3-25, c = 1-20, OR = un groupe C1-C15-alcoxy, C1-C15-oxyalkylalcoxy, C1-C15-aryloxy ou C1-C15-oxyarylalcoxy et Y = -NO₃ ; de manière particulièrement préférée un oxoalcoxyde de formule générique MₓO_{y}(OR)_{z}Y_{c} dans laquelle x = 3-15, y = 1-5, z = 10-20, c = 4-10,
R = -CH₃, -CH₂CH₃, -CH₂CH₂OCH₃, -CH(CH₃)₂, -CH(CH₃)CH₂OCH₃, -C(CH₃)₃ et/ou 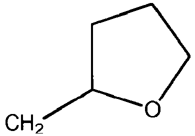 et Y = NO₃.

3. Procédé selon l'une quelconque des revendications précédentes, **caractérisé en ce que** ledit au moins un oxoalcoxyde d'indium est le seul précurseur d'oxyde métallique utilisé dans le procédé.

4. Procédé selon l'une quelconque des revendications précédentes, **caractérisé en ce que** ledit au moins un oxoalcoxyde d'indium se trouve en des proportions de 0,1 à 15% en poids par rapport à la masse totale de la composition.

5. Procédé selon l'une quelconque des revendications précédentes, **caractérisé en ce que** ledit au moins un solvant est un solvant aprotique ou faiblement protique.

6. Procédé selon la revendication 5, **caractérisé en ce que** ledit au moins un solvant a été choisi dans le groupe constitué par le méthanol, l'éthanol, l'isopropanol, l'alcool tétrahydrofurfurylique, le 1-méthoxy-2-propanol, le tert-butanol et le toluène.

7. Procédé selon l'une quelconque des revendications précédentes, **caractérisé en ce que** la composition présente une viscosité de 1 mPa.s à 10 Pa.s.

8. Procédé selon l'une quelconque des revendications précédentes, **caractérisé en ce que** le substrat est constitué de verre, de silicium, de dioxyde de silicium, d'un oxyde de métal ou de métal de transition, d'un métal ou d'un matériau polymère.

9. Procédé selon l'une quelconque des revendications précédentes, **caractérisé en ce que** l'application de la composition anhydre sur le substrat a lieu via un procédé de revêtement, un procédé d'impression, un procédé de pulvérisation, un procédé de revêtement par rotation, un procédé d'imprégnation ou un procédé choisi dans le groupe constitué par le revêtement par ménisque, le revêtement par fente, le revêtement par filière plate et le revêtement par rideau.

10. Procédé selon l'une quelconque des revendications précédentes, **caractérisé en ce que** la conversion a lieu thermiquement par des températures supérieures à 150°C.

11. Procédé selon la revendication 10, **caractérisé en ce qu'**un rayonnement UV, IR ou VIS est irradié avant, pendant ou après le traitement thermique.

12. Oxoalcoxyde d'indium de formule générique
MₓO_{y}(OR)_{z}[O(R'O)ₑH]ₐX_{b}Y_{c}[R"OH]_{d}
dans laquelle
x = 3 - 25,
y = 1 - 10,
z = 3 - 50,
a = 0 - 25,
b = 0 - 20,
c = 1 - 20,
d = 0 - 25,
e = 0, 1,
M = In,
R, R', R" = un radical organique,
X = F, Cl, Br, I,
Y = -NO₃, -NO₂,
à condition que b + c = 1 - 20.

13. Composition de revêtement, contenant au moins un oxoalcoxyde d'indium selon la revendication 12 et au moins un solvant.
